# EUROPÄISCHE PATENTSCHRIFT

(11) **EP 2 501 208 B1**
(45) Veröffentlichungstag und Bekanntmachung des Hinweises auf die Patenterteilung: **22.04.2020**
(21) Anmeldenummer: 12159579.7
(22) Anmeldetag: 15.03.2012
(51) Int. Cl.: H05K 1/18, H05K 3/34, F21K 99/00, H05K 3/40, H05K 3/00, H05K 1/11

(54) **Träger, vorzugsweise für ein elektronisches Bauteil, eine Baugruppe solcher Träger und ein Verfahren zur Herstellung einer Baugruppe solcher Träger**
Holder, in particular for an electronic component, assembly of such holders and a method for producing an assembly of such holders
Support, de préférence pour un composant électronique, un composant d'un tel support et un procédé de fabrication d'un composant d'un tel support

(30) Priorität: 16.03.2011 DE 102011005658
(43) Veröffentlichungstag der Anmeldung: 19.09.2012
(73) Patentinhaber: Sirona Dental Systems GmbH, 64625 Bensheim (DE)
(72) Erfinder: Bierbaum, Thomas, 64625 Bensheim (DE); Rein, Matthias, 64653 Lorsch (DE); Müller, Steffen, 64673 Zwingenberg (DE); Höfle, Michael, 64625 Bensheim (DE); Römer, Thomas, 64668 Rimbach (DE)
(74) Vertreter: Özer, Alpdeniz

(56) Entgegenhaltungen:
- WO-A2-99/08297
- DE-A1- 10 020 099
- DE-A1-102008 059 552
- US-A1- 2001 035 810

## Beschreibung

### Technisches Gebiet

Die Erfindung betrifft eine Baugruppe aus mehreren Trägern, wobei jeder Träger für ein elektrisch kontaktierbares oder für ein mechanisches Bauteil ausgestaltet ist, umfassend eine Trägerplatte mit einer Oberfläche in einer ersten Ebene und eine Anschlussfläche zur Befestigung des Bauteils an der Trägerplatte, wobei die Anschlussfläche für das Bauteil in einer zweiten Ebene angeordnet ist, wobei die Anschlussfläche in der zweiten Ebene in einem Winkel zur Oberfläche in der ersten Ebene angeordnet ist.

### Stand der Technik

Aus dem Stand der Technik sind bereits mehrere Lampen für dentale Handstücke mit Beleuchtungsvorrichtungen bekannt.

Aus der DE 10 2009 007 650 A1 ist ein Beleuchtungsmittel für ein dentales Handgerät mit einer bedrahteten LED mit einem transparenten Gehäuse offenbart. Das Beleuchtungsmittel weist eine Grundplatte mit hindurchgeführten elektrischen Anschlüssen auf. Zwischen der Grundplatte und der LED ist eine elektrisch isolierende Wärmeleitsubstanz angeordnet, um die LED zu kühlen.

Der Nachteil dieses Beleuchtungsmittels ist, dass die LED auf eine aufwendige Art und Weise mittels Leiterdrähten an die Kontakte zur Stromversorgung angeschlossen ist.

In DE 101 95 954 T1 ist die Verwendung von SMD-Chips zum Anbringen an einer Leiterplatte offenbart, wobei Anschlüsse an jeder Kante des Chips mit Elektroden unter Verwendung von automatisierten Lötverfahren verbunden werden. Als automatisierte Lötverfahren könnten beispielsweise die Schwall- und die Reflow-Löttechnik verwendet werden. Als SMD-Bauteile können beispielsweise Vielschichtvaristoren (MLV), Wiederstände, Transistoren und andere Mikroelektronikvorrichtungen verwendet werden.

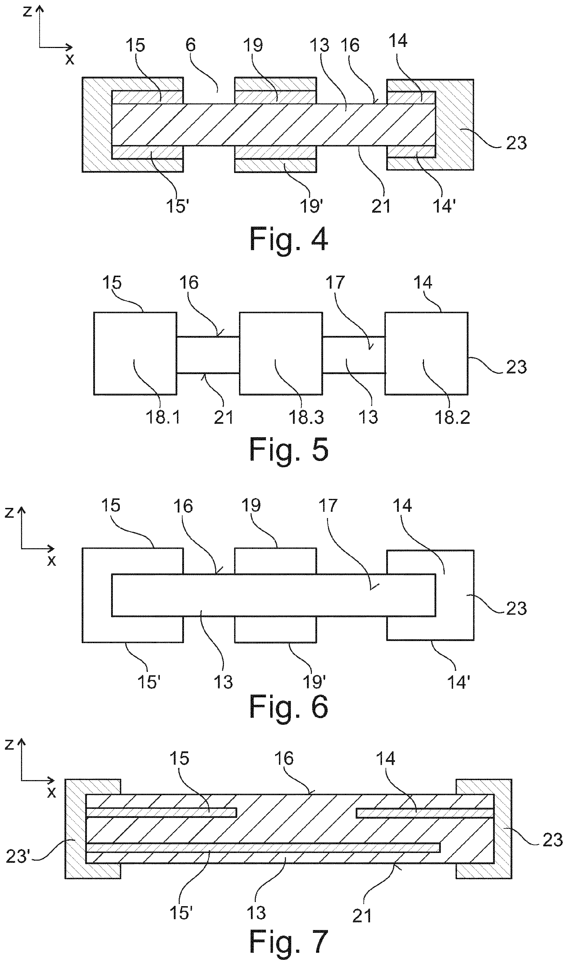

WO 99/08297 A2 offenbart ein Verfahren zur Herstellung von oberflächenmontierbaren, elektronischen Dünnschichtbauelementen, wie Wiederständen, Kondensatoren, Induktoren und Sicherungen. Die Fig. 6 zeigt eine Matrix aus mehreren blockförmigen Komponenten, die entlang der Trennungslinien voneinander getrennt werden können. Eine solche Trennung kann beispielsweise durch Zersägen oder Lasertrennen vorgenommen werden. Jedes auf diese Weise erhaltenes elektronisches Bauelement enthält zwei freie Elektroden, die auch SMD-kompatibel ausgestaltet sein können, wie in Fig. 7 dargestellt.

DE 10 2008 059 552 A1 offenbart ein Leuchtdiodenmodul mit einer Leiterplatte, wobei mehrere Montagebereiche durch Segmentierungsfurchen voneinander abgetrennt sind. Die einzelnen Montagebereiche weisen auch eine Wärmeleitschicht und elektrische Leiterbahnen zum Anschließen eines Halbleiterbauteils auf. Die Segmentierungsfurchen sind Bruchkanten entlang derer das Leuchtdiodenmodul in verschiedene Teilstücke aufgeteilt wird.

DE 100 20 099 A1 offenbart eine Kraftfahrzeugsleuchte umfassend ein Leuchtengehäuse, in dem wenigstens eine Leiterplatte angeordnet ist, die mehrere lichtimitierende Halbleiterbauelemente aufweist, deren Anschlusskontakte jeweils mit elektrischen Leiterbahnen der Leiterplatte verbunden sind. Die Hauptabstrahlrichtung der Halbleiterbauelemente ist in etwa in der Leiterplattenebene oder parallel dazu angeordnet.

Aus der DE 698 16 716 T2 ist ein zahnärztliches Handstück mit einem Hauptteil und einer Lichtquelle zur Beleuchtung der Behandlungsstelle im Mund des Patienten bekannt. Das lichterzeugende Bauelement kann dabei eine LED oder eine Halogenlampe sein. Hierzu ist die LED an Leitungsdrähte angeschlossen, die durch den Turbinenkopf zu Kontakten am proximalen Ende des Turbinenkopfs verlaufen.

Der Nachteil einer solchen Beleuchtungsvorrichtung ist, dass eine LED mit Gehäuse verwendet werden muss, die auf eine aufwendige Art und Weise über Leitungsdrähte angeschlossen wird.

Die Aufgabe der folgenden Erfindung besteht daher darin, einen Träger für ein mechanisches oder elektrisch kontaktierbares Bauteil bereitzustellen, der kompakt ausgestaltet ist und der auf eine einfache Art und Weise automatisiert hergestellt werden kann.

### Darstellung der Erfindung

Die Erfindung betrifft eine Baugruppe von Trägern gemäß Anspruch 1 umfassend ein Halteteil, wobei die einzelnen Träger kammartig am Halteteil angeordnet sind. Jeder der Träger ist für ein elektrisch kontaktierbares oder mechanisches Bauteil ausgestaltet, umfassend eine Trägerplatte mit einer Oberfläche in einer ersten Ebene und eine Anschlussfläche zur Befestigung des Bauteils an der Trägerplatte, wobei die Anschlussfläche in einer zweiten Ebene in einem Winkel zur Oberfläche in der ersten Ebene angeordnet ist, wobei an der Anschlussfläche mindestens ein Kontakt als Teil einer elektrisch leitenden Beschichtung ausgebildet ist.

Das Halteteil ist mit durchbrochenen Leiterbahnen beschichtet, wobei die Leiterbahnen des Halteteils mit den Leiterbahnen der einzelnen Träger so verbunden sind, dass die Träger mit den darauf anzubringenden Bauteilen zum Testen der Funktionalität in Reihe und/oder parallel geschaltet sind.

Durch das Halteteil können die Träger auf einfache Art und Weise aus einer Leiterplatte unter Verwendung von automatisierten Herstellungsmethoden zum Beschichten mit Leiterbahnen und zum Löten hergestellt werden. In einem ersten Schritt kann aus einer Leiterplatte eine Baugruppe mit kammartig angeordneten Trägern herausgearbeitet werden, beispielsweise durch Fräsen. In einem weiteren Schritt können die Kanten metallisiert werden.

Durch die in Reihe und/oder parallel geschalteten Träger kann die Funktionalität geprüft werden. Falls zwischen den Trägern und dem Halteteil eine Sollbruchstelle vorgesehen ist, könnte die Sollbruchstelle auf der Rückseite der Trägerplatte angeordnet sein und die Leiterbahnen, die das Halteteil mit den Anschlüssen für die Bauteile verbinden, kann auf der vorderen Ebene angeordnet sein. Zum Testen kann an den beiden seitlichen Enden des Halteteils eine Spannung angelegt werden.

Ein Vorteil des Trägers ist, dass zum Anbringen des Bauteils an der Anschlussfläche der Trägerplatte ein zeitsparendes automatisiertes Bestück-Verfahren verwendet werden kann, bei dem keine Kontaktdrähte Verwendung finden. Beim SMD-Verfahren erfolgt die Kontaktierung durch direktes Anlöten des SMD-Bauteils an der Anschlussfläche. Dadurch ist der vorliegende Träger besonders kompakt in der Bauweise und weniger störungsanfällig als herkömmliche Träger für elektrische Bauteile.

Der Träger für ein elektrisch kontaktierbares oder mechanisches Bauteil kann beispielsweise so mit einer LED ausgestaltet sein, dass er in seiner Form einem herkömmlichen Beleuchtungsmittel für dentale Handstücke, wie einer herkömmlichen Halogenlampe, entspricht. Der Träger kann dabei mit einem Sockel mit Steckverbindung zum Einsetzen in eine Fassung eines Dentalhandstücks zur Beleuchtung einer zu untersuchenden Stelle in der Mundhöhle eines Patienten ausgeführt sein. Als Bauteil kann auch ein Aktuator, ein Sensor oder ein anderes elektronisches oder ein mechanisches Bauteil wie eine Feder an den Träger angeschlossen werden. Als Bauteil kann vorteilhafterweise ein SMD-Bauteil verwendet werden, um das Kontaktieren oder mechanische Befestigen, beispielsweise durch Anlöten, zu automatisieren. Die Trägerplatte kann aus elektrisch isolierendem oder elektrisch isoliertem Material bestehen und kann aus einer herkömmlichen Leiterplatte hergestellt sein.

Der Winkel zwischen der Oberfläche und der Anschlussfläche beträgt zwischen 45° und 135°, insbesondere 90°. Dadurch kann der Träger kompakt ausgestaltet werden. Falls das Bauteil eine SMD-LED ist, entspricht die Abstrahlrichtung bei einem Winkel von 90° der Anschlussfläche der daran angebrachten LED der Längsachse der Trägerplatte. Mit einer schräg gestellten Anschlussfläche kann eine andere Abstrahlrichtung ermöglicht werden.

Die Trägerplatte weist eine in einem Winkel zur Oberfläche angeordnete Kontaktfläche auf, wobei die Kontaktfläche elektrisch leitend beschichtet und mit dem Kontakt der Anschlussfläche elektrisch verbunden ist.

Dabei kann die Kontaktfläche an einer Seitenkante der Trägerplatte liegen und die Beschichtung der Kante der Trägerplatte wird nach Art einer Leiterbahn verwendet. Diese Kontaktfläche kann dabei in einer anderen Ebene als die Anschlussfläche und die Oberfläche liegen.

Gemäß einer Weiterbildung kann die Trägerplatte eine beschichtete Seitenfläche in einem Winkel zur Oberfläche aufweisen und kann die Beschichtung der Seitenfläche die Kontaktfläche mit der Anschlussfläche elektrisch verbinden.

Dies ermöglich eine Stromführung über verschiedene Ebenen hinweg, beispielsweise von der y-z-Ebene der Kontaktfläche in die x-z-Ebene der Anschlussfläche.

Gemäß einer Weiterbildung kann die Trägerplatte auf der Oberfläche in der ersten Ebene oder parallel dazu mindestens eine Leiterbahn aufweisen, wobei die Leiterbahn mit dem Kontakt der Anschlussfläche elektrisch verbunden ist.

Vorteilhafterweise kann die Leiterbahn auch mit der Kontaktfläche elektrisch verbunden sein. Ein Vorteil des Trägers ist, dass die erste Leiterbahn in einer ersten Ebene und die Anschlussfläche in einer zweiten Ebene angeordnet sein kann. Dies ermöglich eine Stromführung über verschiedene Ebenen hinweg, beispielsweise von der y-z-Ebene der Kontaktfläche in die x-y-Ebene der Leiterbahn und dann in die x-z-Ebene der Anschlussfläche.

Die Leiterbahnen können unter Verwendung herkömmlicher Beschichtungsverfahren als eine Beschichtung aus einem elektrisch leitenden Material, wie beispielsweise Kupfer, auf oder in der Trägerplatte angebracht sein.

Der Träger kann auch mit einem Vorwiderstand versehen werden, der auf der Oberseite in der ersten Ebene beispielsweise durch Aufdrucken angebracht werden kann, um die Leistungsaufnahme der SMD-LED an die Leistungsaufnahme der herkömmlichen Halogenlampe für dentale Handgeräte anzupassen.

Zum Verbinden des Bauteils an der Anschlussfläche kann beispielsweise ein Reflow-Lötverfahren, Wellenlötverfahren oder ein selektives Löten verwendet werden. Das Anbringen sowie das Kontaktieren der Bauteile an den Anschlüssen kann auch durch ein Kontaktklebeverfahren erfolgen. Die erste Leiterbahn kann auch auf der Rückseite der Trägerplatte angeordnet sein.

Das sogenannte Reflow-Löten bzw. das Wiederaufschmelzlöten bezeichnet ein in der Elektrotechnik gängiges Weichlötverfahren zum Löten von SMD-Bauteilen. Im ersten Schritt wird ein Weichlot vor der Bestückung auf die Platine aufgetragen. Der Lotauftrag kann beispielsweise mittels Schablonendruck, Siebdruck, durch Lotformteile oder auch galvanisch erfolgen. Im nächsten Schritt werden dann die Bauteile bestückt. Anschließend wird das aufgebrachte Lot aufgeschmolzen, wobei die bestückten SMD-Bauteile sich durch die Oberflächenspannung des Lotes auf den Kontaktflächen zentrieren und über das Lot der elektrische Kontakt und die Verbindung des Bauteiles mit dem Trägerplatte hergestellt wird.

Auf einer oder mehreren der Ebenen kann zudem beispielsweise eine elektronische Schaltung wie ein IC und/oder ein Widerstand angeordnet werden. Darüber hinaus können auch weitere Bauteile wie mechanische Bauteile oder Widerstände und IC unter Verwendung der oben genannten automatisierten Lötverfahren aufgebracht werden. Die erste Leiterbahn auf der Oberseite in der ersten Ebene kann mit der Beschichtung der Seitenfläche in der seitlichen dritten Ebene elektrisch verbunden sein und zur elektrischen Kontaktierung des Bauteils verwendet werden. Das elektrisch leitende Material der Beschichtung kann eine dünne Schicht aus Gold sein.

Vorteilhafterweise kann die Trägerplatte elektrisch isolierend sein, wobei an der Anschlussfläche elektrische Kontakte als Teil der Beschichtung der Kanten ausgebildet sein können, sodass die Anschlussfläche zum Anlöten eines SMD-Bauteils geeignet ist. Die Kontakte auf der Anschlussfläche können in Form von rechteckigen Kontaktflächen ausgebildet sein.

Dadurch wird es ermöglicht ein SMD-Bauteil, wie beispielsweise eine SMD-LED, unter Verwendung der oben genannten automatischen Lötverfahren an den beiden Kontakten der Anschlussfläche anzulöten.

Unterhalb des Bauteils kann ein Kühlkörper in Form einer weiteren Leiterbahn an der Trägerplatte angebracht werden, der zur Abführung der beim Betrieb eines SMD-Bauteils entstehenden Wärme dient. Ein Teil des Kühlkörpers ist auf der Anschlussfläche und die beiden Enden des Kühlkörpers sind auf der Oberseite und auf der Unterseite der Trägerplatte angebracht, sodass sich insgesamt eine U-förmige Gestalt des Kühlkörpers ergibt.

Die Anschlussfläche der einzelnen Träger kann zur Bereitstellung von Kontakten mit einer Beschichtung beschichtet werden.

Vorteilhafterweise kann jeder der Träger über eine Sollbruchstelle zum Vereinzeln der einzelnen Träger mit dem Halteteil verbunden sein. Dadurch kann jeder der dentalen Träger manuell oder automatisiert in einer Fertigungsanlage durch Ausüben einer Kraft auf die Träger vom Halteteil abgetrennt werden.

Ein weiterer Gegenstand der Erfindung ist eine Baugruppe von mehreren miteinander an einer Verbindungsstelle verbundenen Trägern, die nebeneinander angeordnet sind. Die Träger sind alle in derselben Art und Weise ausgerichtet, sodass die Anschlussfläche stets für eine automatisierte Bestückung oder Verbindung von Bauteilen zugänglich ist.

Dabei kann jeder der Träger mit seiner Trägerplatte einstückig mit dem benachbarten Träger verbunden sein, wobei die Verbindungsstelle vorzugsweise als Sollbruchstelle zum Vereinzeln der einzelnen Träger ausgebildet ist.

Die Erfindung betrifft weiterhin ein Verfahren zur Herstellung der Baugruppe, wobei in einem ersten Schritt aus einer Leiterplatte mittels einer Bearbeitungsvorrichtung die Baugruppe umfassend mehrere Träger herausgearbeitet werden. In einem zweiten Schritt werden bei der Baugruppe die Anschlussfläche, die Seitenfläche und/oder die Kontaktfläche jeder der Träger mittels einer Beschichtungsvorrichtung unter Verwendung eines Kantenmetallisierungsverfahrens mit einer elektrisch leitfähigen Beschichtung beschichtet.

Das Anbringen der Beschichtung an der Kante erfolgt mittels bekannter Verfahren zur Kantenmetallisierung von Standardplatinen. Diese Kantenmetallisierung findet statt, nachdem die umlaufenden Kanten einer Platine oder Leiterplatte mittels Fräsen oder Bohren bearbeitet wurden und gegebenenfalls die gewünschten Löcher in der Platine eingebracht wurden.

Ein Vorteil des beschriebenen Verfahrens ist, dass die Baugruppe mit den Trägern auf eine einfache, herkömmliche Art und Weise automatisiert aus einer Leiterplatte hergestellt werden kann. In der Beschichtungsvorrichtung kann zusätzlich zu der Kantenmetallisierung am Rand der Baugruppe und des Trägers auch eine Beschichtung der Leiterbahnen stattfinden.

Vorteilhafterweise können mittels der Bearbeitungsmaschine im Verbindungsbereich zwischen dem Träger und dem Halteteil oder zwischen benachbarten Trägern Vertiefungen herausgearbeitet werden, um so eine Sollbruchstelle für jeden der Träger herzustellen. Damit ist eine Vereinzelung wie vorstehend bereits beschrieben möglich.

Wenn an der Anschlussfläche jedes der Träger Kontakte ausgebildet sind, kann das Bauteil mittels einer automatischen Lötvorrichtung angelötet werden.

Falls die SMD-Bauteile LED's sind, können in der Fertigungsanlage an den Positionen der einzelnen LED's optische Sensoren vorgesehen werden, die die Lichtstärke der LED's testen. Bei einer fehlerhaften LED erfolgt dann eine Fehlermeldung an den Benutzer.

### Kurzbeschreibung der Zeichnungen

Die Erfindung wird anhand der Zeichnungen erläutert. Es zeigt, die
- Fig. 1: eine Baugruppe mit mehreren Trägern;
- Fig. 2: die Baugruppe aus Fig. 1 mit an den Trägern angebrachten elektronischen Bauteilen;
- Fig. 2A: eine Verbindungsstelle des Trägers der Baugruppe aus den Fig. 1 und 2 in perspektivischer Ansicht im Detail,
- Fig. 2B: die Verbindungsstelle aus Fig. 2A in Seitenansicht;
- Fig. 3: einen der dentalen Träger aus Fig. 2 im Detail und losgelöst aus der Baugruppe;
- Fig. 4: einen Schnitt durch den Träger entlang der Schnittlinie aus Fig. 3;
- Fig. 5: eine Draufsicht auf den Träger aus Fig. 1;
- Fig. 6: eine Draufsicht auf einen alternativ ausgebildeten Träger aus Fig. 1;
- Fig. 7: einen alternativen Träger mit einem Trägerteil nach Art einer mehrschichtigen Leiterplatte;
- Fig. 8: ein Schnitt durch den Träger aus Fig. 3;
- Fig. 9: einen alternativen Träger und eine alternative Baugruppe mit einem entlang der Längsachse angeordneter Verbindungsstelle.

### Ausführungsbeispiele

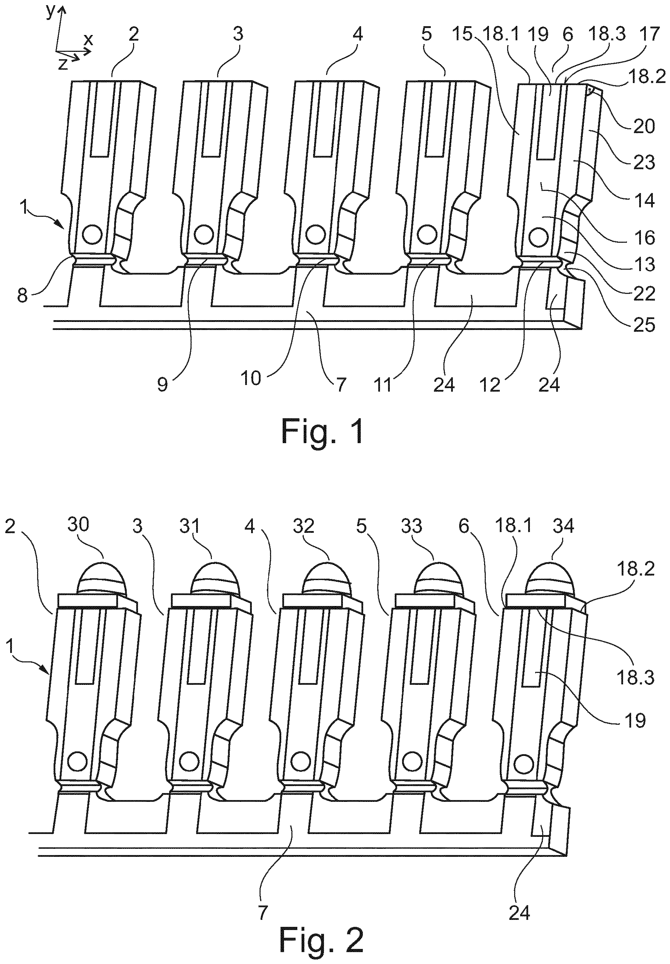

Die Fig. 1 zeigt eine Baugruppe 1, umfassend mehrere Träger 2-6 und ein Halteteil 7, wobei die Träger 2-6 zueinander in einer x-Richtung beabstandet am Halteteil 7 und in einer y-Richtung sich von diesem weg erstreckend angeordnet sind, sodass die Baugruppe in ihrer Art an einen Kamm erinnert, wobei die Träger 2-6 den Zinken des Kammes entsprechen. Jeder der Träger 2-6 weist eine Verbindungsstelle 8-12 zum Halteteil 7 hin auf, die zwischen dem jeweiligen Träger 2-6 und dem Halteteil 7 angeordnet ist.

Jeder der Träger 2-6 umfasst eine Trägerplatte 13, auf der eine erste Leiterbahn 14 und eine dazu in x-Richtung beabstandete zweite Leiterbahn 15 in einer gemeinsamen x-y-Ebene der Trägerplatte 13 angeordnet sind, die hier der Oberseite 16 der Trägerplatte 13 entspricht.

Die Ausbildung der Leiterbahnen 14, 15 in einer x-y-Ebene der Trägerplatte 13 ist für die Erfindung nicht unbedingt erforderlich, die Leiterbahnen begünstigen aber die mechanische Stabilität der Beschichtung auf den Flächen 17, 22, 23 und können die elektrische Leitfähigkeit verbessern, wenn sich diese Beschichtung auch auf die Leiterbahn erstreckt.

Wie dargestellt, ist jeder der Träger 2-6 über seine Trägerplatte 13 einstückig mit dem Halteteil 7 verbunden, sodass das Halteteil 7 und die Trägerplatte 13 aus im Wesentlichen demselben Grundmaterial bestehen. Dieses Grundmaterial kann eine herkömmliche Leiterplatte aus einem elektrisch isolierenden Kunststoff mit einer flächigen Ausdehnung in einer x-y-Ebene und einer Dicke in einer Richtung z und Leiterbahnen in dieser x-y-Ebene sein, wobei die Leiterplatte zur Ausbildung einer Vielzahl von Trägern von einer Kante her gesehen in y-Richtung ein Stück weit eingesägt wird, sodass sich wegen des erzeugten Spaltes mit einer Spaltbreite in x-Richtung insgesamt ein kammartig ausgebildeter Rand einstellt.

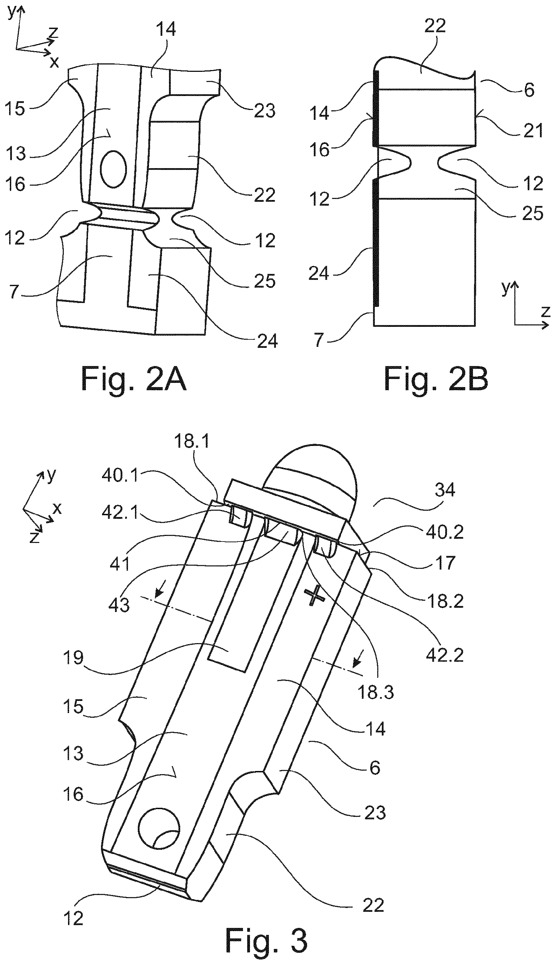

Die Verbindungsstelle 8-12 ist als Sollbruchstelle zum Vereinzeln der einzelnen Träger 2-6 von dem Halteteil 7 ausgebildet. Dazu ist die Materialdicke an der Verbindungsstelle 8-12 gegenüber der Materialdicke des Trägers 2-6 und des Halteteils 7 verringert, indem von beiden in der x-y-Ebene befindlichen Seiten, also von der in der Zeichenebene liegenden und dargestellten Oberseite 16 und der unterhalb der Zeichenebene liegenden und daher nicht sichtbaren Unterseite der Baugruppe in z-Richtung eine Nut eingebracht wurde. Beim Einbringen der Nut werden die auf der Oberseite 16 liegenden Leiterbahnen 14,15 durchtrennt. Die Verbindungsstelle 12 ist später in den Fig. 2A und 2B im Detail dargestellt.

Der Träger 2-6 weist eine Anschlussfläche 17 auf, die zur x-y-Ebene in einem Winkel 20 von 1° bis 90° steht, wobei im dargestellten Fall die Anschlussfläche 17 vollständig in der x-z-Ebene liegt, da der Winkel 90° beträgt. Die Anschlussfläche 17 liegt hier quer zur Längsachse des Trägers 6.

An dieser Anschlussfläche 17 sind elektrisch voneinander getrennte Anschlüsse für ein elektronisches Bauteil angeordnet, die zwei elektrische Kontakte 18.1, 18.2 umfassen. Zwischen den beiden elektrischen Kontakten 18.1, 18.2 ist ein weiterer Kontakt 18.3 des Kühlkörpers 19 vorhanden, wobei der Kühlkörper 19 in Form einer weiteren Leiterbahn, die mittig auf der Oberfläche 16 der Trägerplatte und wie später dargestellt dann unterhalb des noch anzubringenden Bauteils angeordnet ist und die betriebsbedingte Wärme des Bauteils an die beiden Enden des Kühlkörpers 19 auf der Oberseite 16 und einer Unterseite abgeführt.

Der Träger 2-6 weist weiterhin eine seitliche Kontaktfläche 22 und eine Seitenfläche 23 in einer y-z-Ebene auf, die mit einem oder mehreren leitenden Materialien wie z.B. mit Kupfer oder Gold beschichtet sind, derart, dass die Kontaktfläche 22 mit dem Kontakt 18.2 an der Anschlussfläche 17 und wahlweise auch mit der Leiterbahn 14 elektrisch verbunden ist.

Dasselbe gilt für die mit der Leiterbahn 15 verbundene Seitenfläche und den dort angebrachten Kontaktbereich, die der Kontaktfläche 22 und der Seitenfläche 23 gegenüberliegend am Träger 2-6 angebracht sind. Auch wenn die elektrische Verbindung der Kontakte 18.1, 18.2 allein über die Beschichtung an der Kante grundsätzlich ausreicht, sind die Kontakte 18.1, 18.2 zusätzlich mit der jeweils benachbarten Leiterbahn 14, 15 elektrisch verbunden.

Auch wenn die Leiterbahnen 14 und 15 durch die Ausgestaltung der Verbindungsstelle 8-12 als Sollbruchstelle gegenüber am Halteteil 7 angeordneten Leiterbahnen 24 unterbrochen sind, bleiben die Leiterbahnen 14,15 mit den Leiterbahnen 24 des Halteteils 7 über die seitliche Kontaktfläche 22 elektrisch verbunden. Wesentlich dafür ist, dass auch das Halteteil 7 an seiner in z-Richtung in die Zeichenebene hinein verlaufenden Seitenkante 25 eine elektrisch leitende Beschichtung aufweist, die mit der Leiterbahn 24 elektrisch verbunden ist. Da sich die Vertiefung in der Sollbruchstelle nicht über die gesamte Z-Richtung erstreckt, bleibt an der Verbindungsstelle ein leitender Bereich der Beschichtung bestehen.

Zum Beschichten der Trägerplatte 13 mit den Leiterbahnen 14, 15 der Oberseite 16, der Leiterbahnen auf der Unterseite und der seitlichen Leiterbahnen auf der seitlichen Ebene 23, der Kontaktflächen 22, der Kontakte 18 und des Kühlkörpers 19 wird eine automatisierte Beschichtungsvorrichtung zur Beschichtung von Leitplatten mit einem leitenden Material verwendet. Dabei wird die Leiterplatte rundum, also dreidimensional, in einem Bad auf den dafür vorgesehenen Flächen beschichtet.

Die Fig. 2 zeigt die Baugruppe 1 aus Fig. 1 mit an den Trägern 2-6 angebrachten elektronischen Bauteilen 30-34, die in der dargestellten Ausführungsform SMD-LED's sind. Die elektronischen Bauteile 30-34 wurden mittels eines Lötverfahrens wie des Reflow-Lötverfahrens oder des Wellenlötverfahrens an die an der Anschlussfläche 17 vorgesehenen Kontakte 18.1, 18.2 der Leiterbahnen 14, 15 und an den Kontakt 18.3 des Kühlkörpers 19 aus Fig. 1 gelötet.

Die Leiterbahnen 14, 15 des Trägers 2-6 dienen im wesentlichen dazu, das Bauteil 30-34 an dem Träger 2-6 mittels herkömmlicher und erprobter Techniken befestigen zu können, auch wenn es sich nur um ein rein mechanisches Bauteil handelt. In diesem Fall spielt die Stromführung über den Träger zum Bauteil hin keine Rolle und es geht vielmehr ausschließlich um die Befestigung. Darüber hinaus kann es sein, dass die zusätzlich aufgebrachte elektrisch leitende Beschichtung nicht über eine ausreichende mechanische Stabilität verfügt, sodass die Befestigung der elektrisch zu kontaktierenden Bauteile an der Beschichtung selbst nicht mit ausreichender Sicherheit möglich ist und nur in Verbindung mit den Leiterbahnen 14, 15, die dabei selbst beschichtet sein können, gewährleistet werden kann.

Die Träger 2-6 sind dabei untereinander elektrisch verbunden, so dass im letzten Schritt des Herstellungsprozesses bei der Qualitätsprüfung die Funktion von am Träger angebrachten Bauteilen überprüft werden kann, indem die ganze Baugruppe auf einmal geprüft wird.

Fig. 2A zeigt die als Sollbruchstelle ausgebildete Verbindungsstelle 12 des Trägers 2-6 der Baugruppe 1 aus den Fig. 1 und 2 in perspektivischer Ansicht im Detail. Die Materialdicke an der Verbindungsstelle 8-12 ist gegenüber der Materialdicke des Trägers 2-6 und des Halteteils 7 verringert, indem von beiden Seiten, also von der in der Zeichenebene liegenden und dargestellten Oberseite 16 und der unterhalb der Zeichenebene liegenden und daher nicht sichtbaren Unterseite der Baugruppe in z-Richtung eine Nut eingebracht wurde.

Fig. 2B zeigt die Verbindungsstelle 12 aus Fig. 2A in einer Seitenansicht auf das Halteteil 7 und den Träger 6, sodass außer der Oberseite 16 mit den Leiterbahnen 14, 24 auch die Unterseite 21 und die sowohl von der Oberseite 16 als auch von der Unterseite 21 in z-Richtung ausgebildete Verringerung der Materialstärke erkennbar ist.

Die Fig. 3 zeigt den Träger 6 mit dem angelöteten elektronischen Bauteil 34 in Form einer SMD-LED, wobei die Träger 6 vom Halteteil 7 aus Fig. 2 abgetrennt wurde, beispielsweise durch Abknicken aus der x-y-Ebene in z-Richtung. Der Träger 6 entspricht in seiner Form und seinen Abmessungen einer herkömmlichen Halogenlampe für dentale Handstücke, so dass eine herkömmliche Halogenlampe, bestehend aus einem Sockel und einem Leuchtkörper gegen den vorliegenden Träger 6 mit der LED ausgetauscht werden kann, da der Träger 6 an seiner Verbindungsstelle 12 zum Halteteil 7 aus Fig. 2 nach seiner Art und in seinen Abmessungen als Sockel mit seitlichen Kontaktflächen 22 ausgebildet ist, sodass eine Kontaktierung des Sockels in der y-z-Ebene möglich ist. Durch die Leiterbahn 14, 15 ist auch eine Kontaktierung des Sockels in der x-y-Ebene möglich, wodurch eine Anpassung an die jeweilige Fassung, in welche der Träger mit seinem Sockel eingesteckt wird, möglich ist.

Die SMD-LED 34 weist zwei Kontakte 40.1, 40.2 zur Kontaktierung an die Kontakte 18.1, 18.2 an der Anschlussfläche 17 bzw. an die auf der Oberseite 16 angeordneten Leiterbahnen 14, 15 und einen Kontakt 41 zur Kontaktierung der SMD-LED 34 an den Kühlkörper 19 auf.

Die elektrische Verbindung des Kontakts 40.2 des elektrischen Bauteils 34 erfolgt ausgehend von der Kontaktfläche 22 am als Sockel ausgebildeten Ende des Trägers 6 zu der Seitenfläche 23 und zu der stirnseitigen Anschlussfläche 17 mit dem Kontakt 18.2 hin, wobei auch eine elektrisch leitende Verbindung der Kontaktfläche 22 mit der Leiterbahn 14 besteht. Gleiches gilt für die Leiterbahn 15 und für den Kontakt 18.1, die mit dem Kontakt 40.1 in elektrischer Verbindung stehen. Die elektrische Verbindung der Kontakte 40.1, 40.2 mit den Leiterbahnen 15, 14 erfolgt über Lötstellen 42.1, 42.2. Eine weitere Lötstelle 43 verbindet das elektronische Bauteil, hier eine LED, mit dem Kühlkörper 19, der hier als Leiterbahn auf dem Trägerteil 13 ausgebildet ist und der zwischen den für die elektrische Verbindung sorgenden Leiterbahnen 14, 15 angeordnet ist.

In Fig. 4 ist ein Schnitt durch den Träger 6 entlang der Schnittlinie aus Fig. 3 gezeigt. Es ist zu erkennen, dass die Trägerplatte 13 an ihrer Seitenfläche 23 und auf einem Teil der Oberseite 16 und der Unterseite 21 eine elektrisch leitende Beschichtung aufweist, die die Leiterbahn 14, 15 bildet. Der genaue Schichtaufbau der elektrisch leitenden Schichten spielt für die Erfindung keine Rolle, solange sichergestellt ist, dass eine Stromleitung von der y-z-Ebene in die x-y-Ebene erfolgt. So muss die Leiterbahn 14, 15 und der Kühlkörper 19 und die Beschichtung an der Seitenfläche 23 nicht aus demselben Material sein, die Leiterbahnen 14, 15 und der Kühlkörper können aus einem Material, in der Regel aus Kupfer bestehen und die Beschichtung an der Seitenfläche kann aus Gold sein. Dies gilt auch für die gesamte Baugruppe 1 aus Fig. 1.

Die Kantenbeschichtung von Leiterplatten ist dem Prinzip nach bekannt, die besondere Art der Stromführung zur Bereitstellung einer dentalen Lampe als Ersatz für eine Halogenlampe sowie die besondere Art der Bereitstellung des Trägers als Teil einer Lampe schafft aber eine wesentliche Vereinfachung bei der Herstellung von kleinen Lampen, wie etwa für Dentalhandstücke.

Der Vollständigkeit halber wird darauf hingewiesen, dass die Leiterbahnen 14, 15 über die elektrisch isolierende Trägerplatte 13 elektrisch gegeneinander isoliert sind.

In Fig. 5 ist eine Draufsicht auf den Träger 6 aus Fig. 1 dargestellt, wobei die Anschlussfläche 17 in der Zeichenebene liegt. An der Anschlussfläche 17 sind wie in Fig. 1 mit der Leiterbahn 14, 15 und der Seitenfläche 23 verbundene Kontakte 18.1, 18.2 vorhanden, an welche das elektronische Bauteil angelötet werden kann. Auch die thermische Verbindung des Bauteils mit dem Kühlkörper erfolgt über einen an der Anschlussfläche vorgesehenen mittleren Kontakt 18.3.

In Fig. 6 ist eine Draufsicht auf einen alternativ ausgebildeten Träger 6 aus Fig. 1 dargestellt, wobei die Anschlussfläche 17 in der Zeichenebene liegt. Hier ist zu erkennen, dass auf der Oberseite 16 der Trägerplatte 13 die Leiterbahnen 14, 15 und der Kühlkörper 19 aufgebracht sind und dass die Trägerplatte 13 auf der Seitenfläche 23 eine Beschichtung trägt, wobei auch auf der Unterseite 21 Leiterbahnen 14', 15' und ein Kühlkörper 19' vorgesehen sind. Kontakte 18.1, 18.2 aus Fig. 1 sind hier nicht vorhanden, die Anschlussfläche 17 ist frei.

Obwohl für die vorliegende Erfindung in einer einzigen x-y-Ebene angeordnete Leiterbahnen ausreichen, die mit der Beschichtung der in y-z-Ebene verlaufenden Seitenflächen elektrisch verbunden sind, um ein in der x-z-Ebene angeordnetes Bauteil elektrisch zu kontaktieren, können in weiteren x-y-Ebenen angeordnete Leiterbahnen vorgesehen sein, etwa zusätzlich zu der Oberseite noch auf der Unterseite.

Es ist auch vorstellbar, in der Trägerplatte 13 selbst angeordnete Leiterbahnen 14, 15, 15' vorzusehen, wie dies in Fig. 7 für einen alternativen Träger mit einer Trägerplatte 13 nach Art einer mehrschichtigen Leiterplatte im Schnitt gezeigt ist. Die Leiterbahnen liegen hier eingebettet zwischen der Oberseite 16 und der Unterseite 21. Wesentlich ist hier, dass durch die Beschichtung der Kanten eine elektrische Verbindung der Seitenfläche 23, 23' mit den zugeordneten Leiterbahnen 15, 15' einerseits bzw. 14 andererseits vorhanden ist.

In Fig. 7 ist ein Schnitt durch den Träger 6 aus Fig. 3 in einer y-z-Ebene parallel zu der Längsachse des Trägers 6 im Bereich der Leiterbahn 14 dargestellt. Dabei weist die Trägerplatte 13 des Trägers 6 auf der Oberseite 16 des Trägers die Leiterbahn 14 auf und die Leiterbahn ist zusammen mit der Anschlussfläche 17 und an der Unterseite 21 mit einer Beschichtung versehen, die an der Anschlussfläche 17 den Kontakt 18.2 zum Kontakt 40.2 des Bauteils 34 hin bildet. Die Verbindung des Bauteils 34 mit der Trägerplatte erfolgt über eine Lotschicht 50, die die mechanische Verbindung bewirkt und, sollte dies wie im Falle einer SMD-LED erforderlich sein, auch die elektrische Verbindung, wofür die Lotschicht 50 dann elektrisch leitfähig ist. Es ist ersichtlich, dass die Trägerplatte an der Oberseite 16 nicht unbedingt eine Leiterbahn 14 tragen muss. Solange die Beschichtung vorhanden ist, kann die elektrische Leitung über die Beschichtung bewirkt werden, wie es etwa auf der Unterseite 21 der Trägerplatte 6 der Fall wäre.

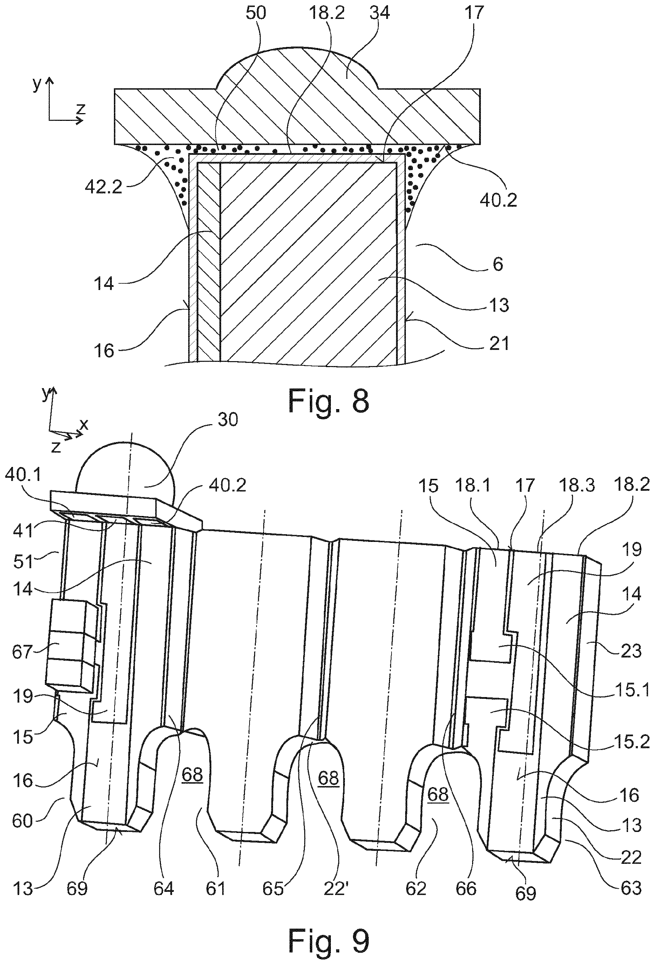

In der Fig. 9 ist eine weitere Ausführungsform eines erfindungsgemäßen Trägers 60 und eine alternative erfindungsgemäße Baugruppe 51 aus mehreren nebeneinander angeordneten Trägern 60-63, wobei jeweils die benachbarten Träger 60-63 über eine parallel zu der Längsachse des Trägers 60-63 verlaufende Verbindungsstelle 64-66 miteinander verbunden sind. Die Verbindungsstelle 64-66 verläuft in einer y-Richtung, wohingegen die Verbindungsstelle 8-12 aus den Fig. 1, 2 in einer x-Richtung verläuft. Die Verbindungsstelle 64-66, welche als Sollbruchstelle ausgeführt ist, liegt in diesem Ausführungsbeispiel also quer zur Längsachse des Trägers 6 und quer zur Anschlussfläche 17 und befinden sich in diesem Ausführungsbeispiel an den späteren Seitenflächen des vereinzelten Trägers. Ein Halteteil 7 aus Fig. 1 entfällt.

Die elektrische Verbindung der Kontaktfläche 22 zu den Kontakten 18.1 bzw. 18. geschieht über die Leiterbahn 14 bzw. 15. Die Leiterbahn 15 ist in diesem Ausführungsbeispiel als unterbrochene Leiterbahn mit den Lötflächen 15.1 und 15.2 dargestellt, wobei die Träger 61, 62 aus Gründen der Übersichtlichkeit keine Leiterbahnen oder Bauteile tragen.

Mit diesen Lötflächen 15.1, 15.2 kann ein weiteres elektrisch kontaktierbares Bauteil 67 auf der Oberfläche 16 aufgelötet werden, wie für den Träger 60 mit den Bauteilen 67 und 30 dargestellt. Dieses Bauteil 67 kann zum Beispiel ein Widerstand zur Stromeinstellung sein.

Über die Seitenkante 23 bzw. deren gegenüberliegenden Seite der außenliegenden Träger 60, 63, die keinen Nachbarn aufweisen, können die Träger 60-63 der Baugruppe 51 in einem Schritt als Kette geprüft werden, wenn alle Bauteile angebracht sind, da an der Seitenkante 23' der Verbindungsstelle 64-66 zur Kontaktfläche 22 hin jeweils noch eine beschichteter Übergangsbereich 22' übrig bleibt und zwei benachbarte Träger über die Verbindungsstelle 64-66 hinweg elektrisch miteinander verbindet.

Wesentlich ist, dass auch hier eine Beschichtung der Kontaktfläche 22 und der Anschlussfläche 17 zur Ausbildung der Kontakte 18.1-18.3 vorgenommen wurde, sodass eine elektrische Kontaktierung des Bauteils 30 über die Kontaktfläche 22 möglich ist. Dabei kann die gesamte Baugruppe 51 einer Kantenbeschichtung unterzogen werden, um die Kontaktfläche 22, die Kontakte 18.1-18.3 und die Seitenfläche 23 zu beschichten. Dabei ist es in diesem Ausführungsbeispiel unerheblich, ob die Verbindungsstelle 64-66 selbst mit der Beschichtung versehen ist oder nicht.

In Fig. 9 ist außerdem zu erkennen, dass das Bauteil 30 an seiner Unterseite drei verschiedene Bereiche aufweist, die den Kontakt 40.1, 40.2 für die elektrische Kontaktierung mit den Kontakten 18.1, 18.2 und den Kontakt 41 für die wärmeableitende Kontaktierung mit dem Kontakt 18.3 zu dem Kühlkörper 19 hin darstellen, wobei die Lötstellen 42.1, 42.2 aus Fig. 3 und Fig. 8 nicht dargestellt sind.

Der Träger kann über die Kontaktfläche 22 und die in dieser Ansicht nicht sichtbare gegenüberliegende Kontaktfläche in x-Richtung elektrisch kontaktiert werden und über die Leiterbahnen 14, 15 in einer z-Richtung. Die Kontaktierung des elektrischen Bauteils 30 erfolgt in einer y-Richtung.

Damit eine Kantenbeschichtung der Trägerplatte 13 in diesem Bereich möglich ist, ist die Trägerplatte 13 in dem Bereich der Kontaktfläche in ihrer Ausdehnung in x-Richtung schmaler ausgebildet, sodass zwischen zwei benachbarten Trägern 60-63 jeweils ein Freiraum 68 vorhanden ist. Die Verbindungsstelle 64-66 erstreckt sich also nicht über die gesamte Länge des Trägers in y-Richtung, sondern nur über einen in y-Richtung gesehen oberen Teilbereich. Dadurch entsteht im in y-Richtung gesehen unteren Teilbereich eine Art Sockel. Am unteren Ende des Sockels befindet sich eine Sockelfläche 69, die selbst nicht elektrisch leitend beschichtet ist, um einen Kurzschluss zwischen den seitlichen Kontaktflächen 22 bzw. den Leiterbahnen 14, 15 zu vermeiden.

### Bezugszeichen

- 1: Baugruppe
- 2: Träger
- 3: Träger
- 4: Träger
- 5: Träger
- 6: Träger
- 7: Halteteil
- 8: Verbindungsstelle
- 9: Verbindungsstelle
- 10: Verbindungsstelle
- 11: Verbindungsstelle
- 12: Verbindungsstelle
- 13: Trägerplatte
- 14: Leiterbahn
- 15: Leiterbahn
- 15.1: Lötfläche
- 15.2: Lötfläche
- 16: Oberseite in x-y-Ebene
- 17: Anschlussfläche in x-z-Ebene
- 18.1: Kontakt
- 18.2: Kontakt
- 18.3: Kontakt
- 19: Kühlkörper
- 21: Unterseite
- 22: Kontaktfläche in y-z-Ebene
- 22': Übergangsbereich der Kontaktfläche
- 23: Seitenfläche in y-z-Ebene
- 24: Leiterbahn
- 25: Seitenkante des Halteteils
- 30: Elektrisches Bauteil
- 31: Elektrisches Bauteil
- 32: Elektrisches Bauteil
- 33: Elektrisches Bauteil
- 34: Elektrisches Bauteil
- 40: Kontakt
- 41: Kontakt
- 42: Lötstelle
- 43: Lötstelle
- 50: Lotschicht
- 51: Baugruppe
- 60: Träger
- 61: Träger
- 62: Träger
- 63: Träger
- 64: Verbindungsstelle
- 65: Verbindungsstelle
- 66: Verbindungsstelle
- 67: Bauteil
- 68: Freiraum
- 69: Sockelunterseite

## Patentansprüche

1. Baugruppe (1) aus mehreren Trägern (2-6), wobei jeder Träger (2-6; 60-63) für ein elektrisch kontaktierbares oder für ein mechanisches Bauteil (30-34) ausgestaltet ist, umfassend eine Trägerplatte (13) mit einer Oberfläche (16) in einer ersten Ebene und eine Anschlussfläche (17) zur Befestigung des Bauteils (30-34) an der Trägerplatte (13), wobei die Anschlussfläche (17) für das Bauteil (30-34) in einer zweiten Ebene angeordnet ist, wobei die Anschlussfläche (17) in der zweiten Ebene in einem Winkel zur Oberfläche (16) in der ersten Ebene angeordnet ist, wobei an der Anschlussfläche (17) mindestens ein Kontakt (18.1, 18.2; 18.3) als Teil einer elektrisch leitenden Beschichtung ausgebildet ist, wobei der Winkel zwischen der Oberfläche (16) und der Anschlussfläche (17) zwischen 45° und 135° beträgt, wobei die Trägerplatte (13) eine in einem Winkel zur Oberfläche (16) angeordnete Kontaktfläche (22) aufweist, wobei die Kontaktfläche (22) elektrisch leitend beschichtet und mit dem Kontakt (18.1, 18.2) der Anschlussfläche (17) elektrisch verbunden ist, wobei die einzelnen Träger (2-6) zueinander beabstandet an einem Halteteil (7) angeordnet und über ihre Trägerplatte (13) an einer Verbindungsstelle (8-12) mit dem Halteteil (7) verbunden sind,
**dadurch gekennzeichnet, dass** die Trägerplatte (13) eine beschichtete Seitenfläche (23) in einem Winkel zur Oberfläche (16) aufweist und dass die Beschichtung der Seitenfläche (23) die Kontaktfläche (22) mit der Anschlussfläche (17) elektrisch verbindet, wobei das Halteteil (7) mit durchbrochenen Leiterbahnen (24) beschichtet ist, wobei die Leiterbahnen (24) des Halteteils (7) mit den Leiterbahnen (14, 15) der einzelnen Träger (2-6) derart verbunden sind, dass die Träger (2-6) mit den darauf angebrachten Bauteilen (30-34) zum Testen der Funktionalität der Bauteile (30-34) in Reihe oder parallel geschaltet sind.

2. Baugruppe (1) nach Anspruch 1, **dadurch gekennzeichnet, dass** jeder der Träger (2-6) mit seiner Trägerplatte (13) einstückig mit dem Halteteil (7) verbunden ist, wobei die Verbindungsstelle (8-12) vorzugsweise als Sollbruchstelle zum Vereinzeln der einzelnen Träger (2-6) von dem Halteteil (7) ausgebildet ist.

3. Baugruppe (1) nach Anspruch 1 oder 2, **dadurch gekennzeichnet, dass** die Verbindungsstelle (8-12) an der Trägerplatte (13) gegenüberliegend zu der Anschlussfläche (17) für das Bauteil (30-34) an die Trägerplatte (13) angeordnet ist.

4. Verfahren zur Herstellung der Baugruppe nach Anspruch 1, **dadurch gekennzeichnet, dass** aus einer Leiterplatte mittels einer Bearbeitungsvorrichtung die Baugruppe (1;51) mit den Trägern (2-6; 60-63) herausgearbeitet werden und dass bei der Baugruppe (1;51) die Anschlussfläche (17) der Trägerplatte (13), die Seitenfläche (23) und/oder die Kontaktfläche (22)jeder der Träger (2-6;60-63) unter Verwendung eines Kantenmetallisierungsverfahrens beschichtet werden, wobei das Halteteil (7) mit durchbrochenen Leiterbahnen (24) beschichtet wird, wobei die Leiterbahnen (24) des Halteteils (7) mit den Leiterbahnen (14, 15) der einzelnen Träger (2-6) derart verbunden werden, dass die Träger (2-6) mit den darauf angebrachten Bauteilen (30-34) zum Testen der Funktionalität der Bauteile (30-34) in Reihe oder parallel geschaltet sind.

5. Verfahren nach Anspruch 4, **dadurch gekennzeichnet, dass** mittels der Bearbeitungsmaschine zwischen dem Träger (2-6) und dem Halteteil (7) oder zwischen benachbarten Trägern (60-63) im Verbindungsbereich (8-12; 64-66) Vertiefungen herausgearbeitet werden, um so eine Sollbruchstelle herzustellen.

6. Verfahren nach Anspruch 4 oder 5, **dadurch gekennzeichnet, dass** ein Bauteil (30-34) an mindestens einem Kontakt (18.1, 18.2) der Anschlussfläche (17) befestigt wird.

## Claims

1. An assembly (1) of a plurality of holders (2-6), each holder (2-6; 60-63) being designed for an electrically contactable or for a mechanical component (30-34), comprising a holder plate (13) having a surface (16) in a first plane and a connection surface (17) for fastening the component (30-34) to the holder plate (13), wherein the connection surface (17) for the component (30-34) is arranged in a second plane, wherein the connection surface (17) in the second plane is disposed at an angle to the surface (16) in the first plane, wherein at least one contact (18.1, 18.2, 18.3) is formed on the connection surface (17) as part of an electrically conductive coating, wherein the angle between the surface (16) and the connection surface (17) is between 45° and 135°, wherein the holder plate (13) has a contact surface (22) arranged at an angle to the surface (16), wherein the contact surface (22) is coated in an electrically conductive manner and is electrically connected to the contact (18.1, 18.2) of the connection surface (17), wherein the individual holders (2-6) are spaced apart from each other on a retaining part (7) and are connected to the retaining part (7) at a connection point (8-12) via their holder plate (13),
**characterised in that** the holder plate (13) has a coated side surface (23) at an angle to the surface (16) and **in that** the coating of the side surface (23) electrically connects the contact surface (22) to the connection surface (17), wherein the retaining part (7) is coated with perforated conductor tracks (24), wherein the conductor tracks (24) of the retaining part (7) are connected to the conductor tracks (14, 15) of the individual holders (2-6) such that the holders (2-6) are connected in series or in parallel with the components (30-34) mounted thereon in order to test the functionality of the components (30-34).

2. The assembly (1) according to claim 1, **characterised in that** each of the holders (2-6) is integrally connected, by its holder plate (13), to the retaining part (7), wherein the connection point (8-12) is preferably formed as a predetermined breaking point for separating the individual holders (2-6) from the retaining part (7).

3. The assembly (1) according to claim 1 or 2, **characterised in that** the connection point (8-12) on the holder plate (13) is arranged opposite the connection surface (17) for the component (30-34) on the holder plate (13).

4. A method for producing the assembly according to claim 1, **characterised in that** the assembly (1; 51) with the holders (2-6; 60-63) is machined out of a printed circuit board by means of a processing device and **in that**, in the assembly (1; 51), the connection surface (17) of the holder plate (13), the side surface (23) and/or the contact surface (22) of each of the holders (2-6; 60-63) are coated using an edge metallisation process, wherein the retaining part (7) is coated with perforated conductor tracks (24), wherein the conductor tracks (24) of the retaining part (7) are connected to the conductor tracks (14, 15) of the individual holders (2-6) such that the holders (2-6) are connected in series or in parallel with the components (30-34) mounted thereon in order to test the functionality of the components (30-34).

5. The method according to claim 4, **characterised in that**, by means of the processing machine, recesses are machined out between the holder (2-6) and the retaining part (7) or between adjacent holders (60-63) in the connection region (8-12; 64-66), so as to thus produce a predetermined breaking point.

6. The method according to claim 4 or 5, **characterised in that** a component (30-34) is fastened to at least one contact (18.1, 18.2) of the connection surface (17).

## Revendications

1. Composant (1) constitué d'une pluralité de supports (2-6), chaque support (2-6 ; 60-63) étant conçu pour un composant pouvant être mis électriquement en contact ou pour un composant mécanique (30-34), comprenant une plaque de support (13) avec une surface (16) dans un premier plan et une surface de connexion (17) pour fixer le composant (30-34) à la plaque de support (13), la surface de connexion (17) pour le composant (30-34) étant agencée dans un deuxième plan, dans lequel la surface de connexion (17) dans le deuxième plan est disposée selon un angle par rapport à la surface (16) dans le premier plan, au moins un contact (18.1, 18.2, 18.3) étant formé sur la surface de connexion (17) en tant que partie d'un revêtement électriquement conducteur, dans lequel l'angle entre la surface (16) et la surface de connexion (17) est compris entre 45° et 135°, dans lequel la plaque de support (13) présente une surface de contact (22) disposée selon un angle par rapport à la surface (16) dans lequel la surface de contact (22) présente un revêtement électriquement conducteur et est connectée électriquement au contact (18.1, 18.2) de la surface de connexion (17), les supports individuels (2-6) étant espacés les uns des autres sur une partie de maintien (7) et connectés à la plaque de maintien (7) par le biais de leur plaque de support (13) en un point de connexion (8-12),
**caractérisé en ce que** la plaque de support (13) présente une surface latérale revêtue (23) formant un angle avec la surface (16) et **en ce que** le revêtement de la surface latérale (23) connecte électriquement la surface de contact (22) à la surface de connexion (17), l'élément de maintien (7) étant revêtu avec des pistes conductrices perforées (24), les pistes conductrices (24) de la partie de maintien (7) étant connectées aux pistes conductrices (14, 15) des supports individuels (2-6) de telle sorte que le support (2-6) soit connecté en série ou en parallèle aux composants (30-34) montés sur celui-ci pour tester la fonctionnalité des composants (30-34).

2. Composant (1) selon la revendication 1, **caractérisé en ce que** chacun des supports (2-6) est connecté d'un seul tenant à sa plaque de support (13) avec la partie de maintien (7), le point de connexion (8-12) constituant de préférence un point de rupture théorique pour séparer le support individuel (2-6) de la partie de maintien (7).

3. Composant (1) selon la revendication 1 ou 2, **caractérisé en ce que** le point de connexion (8-12) est disposé sur la plaque de support (13) à l'opposé de la surface de connexion (17) pour le composant (30-34) sur la plaque de support (13).

4. Procédé de fabrication du composant selon la revendication 1, **caractérisé en ce que** le composant (1 ; 51) avec les supports (2-6 ; 60-63) sont usinés à partir d'une carte de circuit imprimé au moyen d'un dispositif de traitement et **en ce que**, pour le composant (1 ; 51), la surface de connexion (17) de la plaque de support (13), la surface latérale (23) et/ou la surface de contact (22) de chacun des supports (2-6, 60-63) sont revêtues à l'aide d'un procédé de métallisation de bord, dans lequel la partie de maintien (7) est revêtue des pistes conductrices perforées (24), les pistes conductrices (24) de la partie de maintien (7) et les pistes conductrices (14, 15) des supports individuels (2-6) étant connectées de telle sorte que le support (2-6) soit connecté en série ou en parallèle avec les composants (30-34) fixés sur celui-ci pour tester la fonctionnalité des composants (30-34).

5. Procédé selon la revendication 4, **caractérisé en ce que**, au moyen de la machine de traitement, des évidements sont usinés entre le support (2-6) et la partie de maintien (7) ou entre des supports adjacents (60-63) dans la région de connexion (8-12 ; 64-66), afin de produire un point de rupture théorique.

6. Procédé selon la revendication 4 ou 5, **caractérisé en ce qu'**un composant (30-34) est fixé à au moins un contact (18.1, 18.2) de la surface de connexion (17).
